Europäisches Patentamt

European Patent Office

Office européen des brevets

(11) Numéro de publication: **0 201 372**
A1

## (12) DEMANDE DE BREVET EUROPEEN

(21) Numéro de dépôt: 86400685.3

(22) Date de dépôt: 28.03.86

(51) Int. Cl.4: **H03K 4/02** , G06G 7/28

(30) Priorité: 02.04.85 FR 8505012

(43) Date de publication de la demande:
17.12.86 Bulletin 86/46

(84) Etats contractants désignés:
DE GB IT

(71) Demandeur: THOMSON-CSF
173, Boulevard Haussmann
F-75379 Paris Cedex 08(FR)

(72) Inventeur: Hetyei, Joseph
THOMSON-CSF SCPI-19, avenue de Messine
F-75008 Paris(FR)

(74) Mandataire: Benoit, Monique et al
THOMSON-CSF SCPI 19, avenue de Messine
F-75008 Paris(FR)

(54) Dispositif de génération d'un signal de forme complexe par approximations linéaires.

(57) L'invention a pour objet un dispositif de génération d'un signal de forme complexe par approximations, en utilisant des segments de droite de pentes variables.

Il comporte principalement un générateur (G) de courant constant ($i_o$) alimentant en parallèle un condensateur (C) et un circuit (V) permettant de faire varier le courant $i_l$ qui le traverse. La variation de $i_l$ entraine celle du courant ($i_c$) traversant le condensateur (C). Le signal de sortie S prélevé aux bornes du condensateur (C) est donc une suite de segments linéaires dont la pente est variable de façon discrète en fonction de la variation commandée par le circuit (V) de variation du courant $i_l$.

# DISPOSITIF DE GENERATION D'UN SIGNAL DE FORME COMPLEXE PAR APPROXIMATIONS LINEAIRES

La présente invention a pour objet un dispositif de génération d'un signal de forme complexe, plus particulièrement adapté aux signaux du type impulsion à front de montée rapide ; dans ce dispositif, le signal est formé par approximations en utilisant des segments de droite de pente variable.

Dans le domaine des techniques utilisant des impulsions rapides et notamment dans les systèmes d'aide à la navigation aérienne du type DME (pour "Distance Measurement Equipement", équipement de mesure de distance), il est souvent nécessaire de créer des signaux de type impulsionnel d'une forme bien définie. Dans le cas par exemple des systèmes DME, deux formes précises sont nécessaires :

-pour le DME de navigation, la forme de l'impulsion doit être aussi proche que possible d'une forme gaussienne ou d'une forme en cosinus carré sur chacun des fronts de montée et de descente de l'impulsion ;

-pour le DME-P (ou DME de Précision), le front de montée de l'impulsion doit être sensiblement sinusoïdal alors que le front de descente doit suivre une loi en cosinus carré.

Différents dispositifs sont connus à cet effet.

Parmi ceux-ci, on peut citer les circuits analogiques basés sur la décharge contrôlée d'un circuit oscillant utilisant des éléments LC. L'inconvénient de cette solution est le manque de précision entre le top de départ de la modulation et la forme qui en résulte. Dans le cadre des systèmes DME, cela se traduit par un manque de précision au niveau de la mesure de distance réalisée qui, on le rappelle, utilise comme instant de référence le front montant de l'impulsion.

Des circuits utilisant des techniques numériques sont également connus, comme ceux qui utilisent un convertisseur numérique-analogique fournissant une tension de sortie variable, selon une loi déterminée, en fonction d'une période d'horloge définie. L'impulsion obtenue se présente alors sous la forme d'une série de marches d'escalier et donne un contour approché de la forme souhaitée ; un lissage est alors nécessaire pour obtenir la forme finale de l'impulsion. L'inconvénient majeur de cette solution est lié à la limitation technologique qui se fait sentir dès que le front de montée de l'impulsion devient rapide. En effet, dans ce cas, pour une bonne approximation de la courbe on doit utiliser un grand nombre de marches, c'est-à-dire une horloge très rapide et des convertisseurs numérique-analogique de grande vitesse ; à titre d'exemple, pour des pas ou marches de 20 ns, l'horloge doit fonctionner à 50 MHz, avec un convertisseur susceptible de suivre cette fréquence.

La présente invention a pour objet un dispositif permettant d'engendrer un signal de forme complexe ne présentant pas les limitations précédentes. Il consiste principalement en un circuit analogique fournissant des signaux variables linéairement dans le temps, la pente de variation de ces signaux dans le temps étant elle-même variable sur commande, de façon discrète. Un signal complexe est alors formé selon l'invention, par approximation, en engendrant une série de segments successifs formant un signal dont la pente varie ainsi par valeurs discrètes, de sorte à suivre au mieux la forme recherchée.

Plus précisément, le dispositif selon l'invention comporte des moyens de génération d'un courant constant alimentant deux branches d'un circuit, la première branche comportant un condensateur et la seconde branche des moyens assurant la variation du courant qui y circule et, par suite, du courant circulant dans la première branche ; le signal disponible aux bornes du condensateur varie sensiblement linéairement avec le temps et, ce, avec une pente fonction du courant circulant dans la première branche ; un signal de forme prédéfinie est alors obtenu aux bornes du condensateur, par approximation, en faisant varier de façon discrète la valeur du courant circulant dans la deuxième branche.

D'autres objets, particularités et résultats de l'invention ressortiront de la description suivante, donnée à titre d'exemple non limitatif et illustrée sur les dessins annexés, qui représentent :

-la figure 1, le schéma général du dispositif selon l'invention ;

- la figure 2, un exemple de signal de forme complexe obtenu à l'aide du dispositif selon l'invention ;

-la figure 3, un premier mode de réalisation du dispositif selon l'invention ;

-la figure 4, un exemple de réalisation pratique de la figure précédente ;

-la figure 5, un deuxième mode de réalisation du dispositif selon l'invention ;

-la figure 6, un exemple de réalisation pratique de la figure précédente.

Sur ces différentes figures, les mêmes références se rapportent aux mêmes éléments.

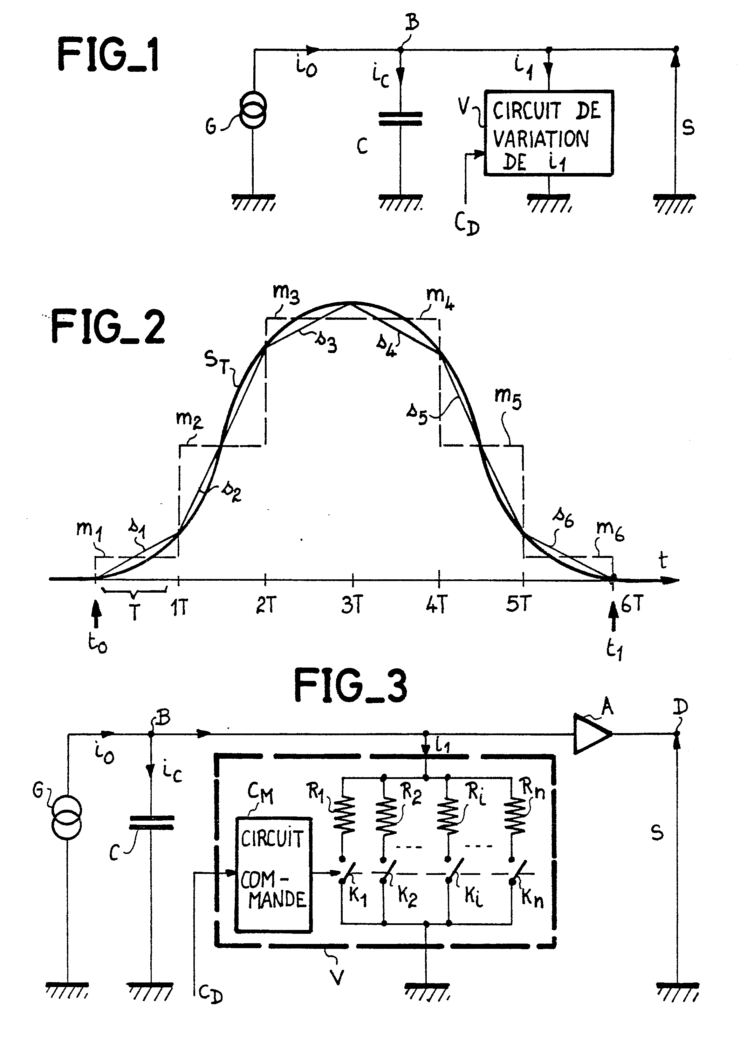

Sur la figure 1, on a donc représenté le - schéma général du dispositif selon l'invention.

Celui-ci comporte des moyens G de génération d'un courant constant, schématisés par une source de courant, connectée entre un point B et la masse, fournissant un courant constant $i_o$. Ce courant alimente deux branches d'un circuit, une première branche comportant, entre le point B et la masse, un condensateur C dans lequel circule un courant $i_c$ et une seconde branche parcourue par un courant $i_l$, également entre le point B et la masse ; ainsi qu'il est connu, on a $i_o = i_c + i_l$. La seconde branche comporte des moyens V assurant la variation du courant $i_l$ et, par suite, la variation du courant $i_c$ circulant dans la première branche. Ces moyens de variation V reçoivent une commande extérieure $C_D$. Le signal de sortie S du dispositif est prélevé aux bornes du condensateur C.

En fonctionnement, le générateur de courant G fournit le courant constant $i_o$ qui charge le condensateur C. La tension aux bornes du condensateur monte (ou descend) en principe linéairement avec une pente p telle que :

$$P = \frac{dv}{dt} = \frac{i_c}{C}$$

où $\underline{v}$ est la tension aux bornes du condensateur et $\underline{t}$ le temps. On obtient donc pour le signal S une tension variant linéairement dans le temps avec la pente p. Lorsqu'on fait varier le courant $i_c$, par action sur le courant $i_l$ de la deuxième branche, la pente p varie. De la sorte, on obtient pour S un signal formé d'une suite de segments, chacun variant linéairement dans le temps mais avec une pente distincte. Le choix des différentes pentes permet de former, par approximation, un signal complexe de forme prédéfinie.

Le fonctionnement de ce circuit est illustré ci-après en liaison avec la figure 2, qui représente un exemple de signal complexe qu'il est possible d'obtenir avec le circuit de la figure 1.

Sur la figure 2 on a donc représenté la forme, repérée $S_T$, du signal que l'on cherche à obtenir ; il s'agit par exemple d'un signal de type impulsionnel de forme gaussienne. On a représenté également l'approximation de ce signal qu'il est possible de faire avec un circuit numérique de l'art antérieur tel que mentionné plus haut : en désignant par $t_o$ et $t_l$ les instants de début et de fin de l'impulsion, on divise la durée $t_l$ -$t_o$ correspondante en un nombre entier de périodes T, six périodes dans l'exemple de la figure ; avec un dispositif de l'art antérieur, on engendre donc six marches d'escalier, repérées $m_l$ à $m_6$. Avec six pas seulement, le dispositif de l'art antérieur ne permet d'obtenir qu'une approximation très grossière de la forme recherchée. Le nombre de pas, pour les impulsions de courte durée - (quelques microsecondes) est limité par la fréquence maximale utilisable par les circuits qui effectuent l'échantillonnage.

On a représenté, pour la même division en six pas T, la suite de segments, repérés $s_l$ à $s_6$, obtenus à l'aide du dispositif de la figure 1 : lors de la première période T, le courant $i_l$ est fixé de façon telle que la charge de la capacité C se fasse avec une pente donnée correspondant sensiblement à la corde sous-tendant le signal $S_T$ dans la période considérée. Au bout de la première période T, sous l'action du circuit V, le courant $i_l$ varie et par suite la pente de la charge de la capacité varie également, de façon à suivre sensiblement l'évolution du signal $S_T$ dans cet intervalle de temps. A la fin de la seconde période T, le courant $i_l$ est à nouveau modifié pour que, corrélativement, la pente de la charge de la capacité C soit amenée à une valeur telle que le segment $s_3$ soit une corde sous-tendant le signal $S_T$ dans cet intervalle ; la fin de la troisième période représentant, dans cet exemple, un axe de symétrie du signal $S_T$, les mêmes variations interviennent mais cette fois sur la pente de décharge de la capacité C pour former les segments $s_4$, $s_5$ et $s_6$.

Il apparaît sur la figure 2 qu'une suite de segments dont la pente varie de façon discrète à des instants prédéfinis permet de réaliser une meilleure approximation d'une forme $S_T$ donnée qu'une série de marches d'escalier et, ce, d'autant plus que la pente de montée ou de descente du signal est raide, à nombre de pas (de durée T) donné, sachant que souvent le nombre de pas ne peut être augmenté (ou la durée T ne peut être réduite), par limitation technologique.

Il est à noter que la durée de chacun des segments $s_1$ à $s_6$ n'est pas obligatoirement la même, comme c'est le cas dans l'exemple de la figure 2.

Par ailleurs, le fonctionnement du circuit V de variation du courant $i_l$ est déclenché à l'instant $t_0$ par la commande extérieure $C_D$. La succession dans le temps des différentes valeurs du courant $i_l$ après l'instant $t_0$ peut être soit réalisée par le circuit V lui-même, soit également commandée ou programmée de l'extérieur. De même pour les valeurs elles-mêmes du courant $i_l$, qui peuvent être soit choisies par commande extérieure, soit connues et engendrées automatiquement par le circuit V.

La figure 3 représente un premier mode de réalisation du schéma général de la figure 1.

Sur la figure 3, on retrouve donc : le générateur G du courant constant $i_0$ ; le condensateur C parcouru par le courant $i_c$, et les moyens de variation V du courant $i_l$ dont la constitution est détaillée ci-après. Au point B est également connecté un amplificateur opérationnel séparateur large bande A, dont la fonction est de découpler le circuit de la figure 3 de la partie située en aval de ce circuit. Le signal S est donc disponible entre la sortie repérée D de cet amplificateur A et la masse.

Les moyens V de variation du courant $i_l$ sont réalisés ici par commutation de résistances. Plus précisément, entre le point B et la masse sont montées $\underline{n}$ voies en parallèle, chacune de ces voies comportant en série une résistance $R_i$ ($\underline{i}$ variant de $l$ à $\underline{n}$) et un interrupteur $K_i$ ($\underline{i}$ variant de la même façon) ; les interrupteurs $K_i$ des différentes voies sont fermés successivement sur commande d'un circuit $C_M$, qui reçoit le signal de commande extérieur $C_D$.

En fonctionnement, lorsqu'un commutateur $K_i$ est fermé, la résistance $R_i$ de la $i^{ème}$ voie est alors mise en parallèle sur le condensateur C, dérive de ce fait une partie ($i_l$) du courant de charge du condensateur C et, par conséquent, change la pente du signal (S) disponible à ses bornes. Les valeurs des résistances $R_l$ ... $R_n$ sont choisies en fonction des différentes (n) pentes souhaitées pour le signal S. Le nombre $\underline{n}$ de voies définit dans ce cas le nombre de segments (ou de pas) formant le signal S.

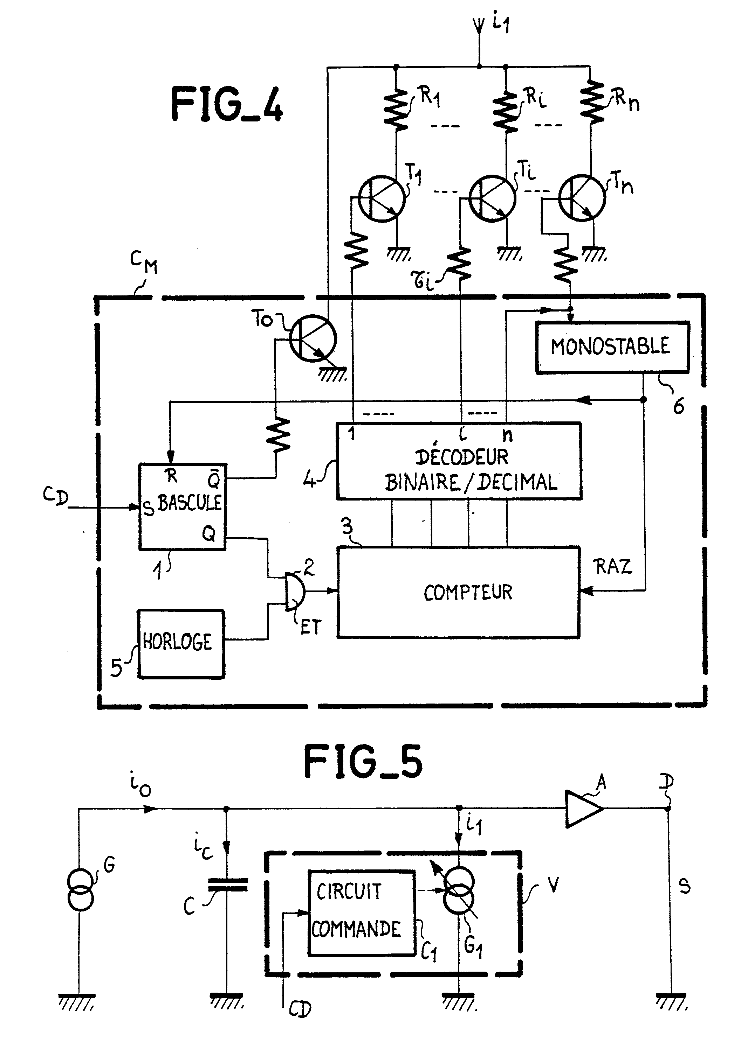

La figure 4 représente plus en détail un mode de réalisation des interrupteurs $K_i$ et de leur circuit de commande $C_M$.

Sur la figure 4, on retrouve donc le courant $i_l$ se partageant entre les $\underline{n}$ voies précédentes et alimentant un transistor $T_0$ du circuit de commande $C_M$. Les commutateurs $K_i$ sont réalisés dans ce mode de réalisation par des transistors $T_i$ ($\underline{i}$ variant

toujours de 1 à $\underline{n}$) qui sont par exemple du type NPN, leur collecteur étant réuni à la résistance $R_i$, leur émetteur à la masse et leur base connectée à un décodeur binaire décimal 4 du circuit de commande $C_M$, par l'intermédiaire d'une résistance $r_i$. Le circuit de commande $C_M$ comporte en outre un compteur 3, un monostable 6, une bascule 1 du type RS, une horloge 5 et une porte ET 2, connectés comme décrit ci-après.

Le fonctionnement du dispositif de la figure 4 est le suivant.

A l'instant $t_0$ de début d'impulsion, la commande $C_D$ est à zéro et la sortie Q de la bascule 1 est à zéro, donc sa sortie $\overline{Q}$ est égale à 1. La sortie Q de la bascule 1 étant reliée à une entrée de la porte ET 2, l'autre entrée de cette porte ET étant reliée à l'horloge 5 et la sortie de la porte ET au compteur 3, il apparaît que les impulsions de l'horloge 5 ne peuvent pas dans ce cas atteindre le compteur 3. Par ailleurs, la sortie $\overline{Q}$ étant à 1 et reliée à la base du transistor $T_0$, celui-ci conduit et le courant $i_l$ auquel est connecté son collecteur traverse le transistor $T_0$ jusqu'à la masse à laquelle est connecté son émetteur : il apparaît ainsi que le condensateur C (figure 3) se trouve en court-circuit et le signal S est alors nul.

Après l'instant $t_0$, la commande $C_D$ (une impulsion de niveau 1) reçue sur l'entrée S de la bascule 1 provoque le passage de la sortie Q à 1, la sortie $\overline{Q}$ étant alors à zéro ; cela provoque le blocage du transistor $T_0$. Parallèlement, la sortie Q étant à 1, la porte ET 2 autorise le passage des impulsions de l'horloge 5 (période T) vers le compteur 3. A ce moment, le compteur 3 compte donc les impulsions d'horloge. Le compteur 3 est relié sur un certain nombre de bits en parallèles au décodeur 4 ; si par exemple le nombre de voies $\underline{n}$ est égal à 10, la sortie du compteur 3 s'exprime sur 4 bits ($2^4$ est supérieur à 10). Les sorties du décodeur binaire-décimal 4 sont au nombre de $\underline{n}$ et reliées chacune respectivement aux $\underline{n}$ bases des transistors $T_i$ par l'intermédiaire des résistances $r_i$. Le décodeur 4 commande alors successivement les transistors $T_l$ à $T_n$ et connecte ainsi successivement les résistances $R_l$ à $R_n$ en parallèle sur le condensateur C (figure 3). Ainsi qu'il a été dit ci-dessus, la valeur des résistances $R_i$ détermine la loi de charge du condensateur C, donc la pente des signaux obtenus successivement à la sortie de l'amplificateur A.

Après $\underline{n}$ signaux d'horloge comptés par le compteur 3, à l'instant $t_l$ (figure 2), le signal de sortie du décodeur 4 dirigé vers la $n^e$ et dernière voie, par ailleurs également adressé au monostable 6, fait basculer ce dernier ; la sortie du monostable est reliée à la fois à l'entrée R (reset) de la bascule 1 et à une entrée de remise à zéro (RAZ) du compteur 3 ; lorsque le monostable 6 bascule ainsi, il change l'état de la bascule 1 et remet à zéro le compteur 3. Le changement d'état de la bascule 1 ferme la porte ET 2, donc arrête le comptage du compteur 3, et fait conduire le transistor $T_0$, ce qui remet le condensateur C en court-circuit et ramène le signal de sortie (S) à zéro.

Le système est alors de nouveau prêt pour créer une nouvelle impulsion si une impulsion de commande ($C_D$) se présente sur l'entrée S de la bascule 1.

La figure 5 représente un deuxième mode de réalisation du dispositif selon l'invention.

Dans ce mode de réalisation, on retrouve le générateur de courant constant G, le condensateur C et les moyens V de variation du courant $i_i$, montés en parallèle, le signal de sortie étant prélevé à la sortie D de l'amplificateur A.

Les moyens V de variation du courant $i_i$ sont ici constitués par un autre générateur de courant $G_1$, ce courant étant variable sous la commande d'un circuit de commande $C_1$ qui reçoit le signal de commande extérieure $C_D$. La commande du générateur de courant $G_1$ permet donc de faire varier le courant $i_i$ qui, par suite, fait varier le courant $i_c$ parcourant le condensateur C.

L'avantage du mode de réalisation de la figure 5 par rapport au mode de réalisation précédent - (figure 3) est qu'il permet d'obtenir des segments - ($s_1...s_6$, figure 2) parfaitement linéaires, du fait que le générateur $G_1$ est un générateur de courant constant pour un segment donné. Cela est obtenu toutefois au prix d'une complexité accrue du dispositif.

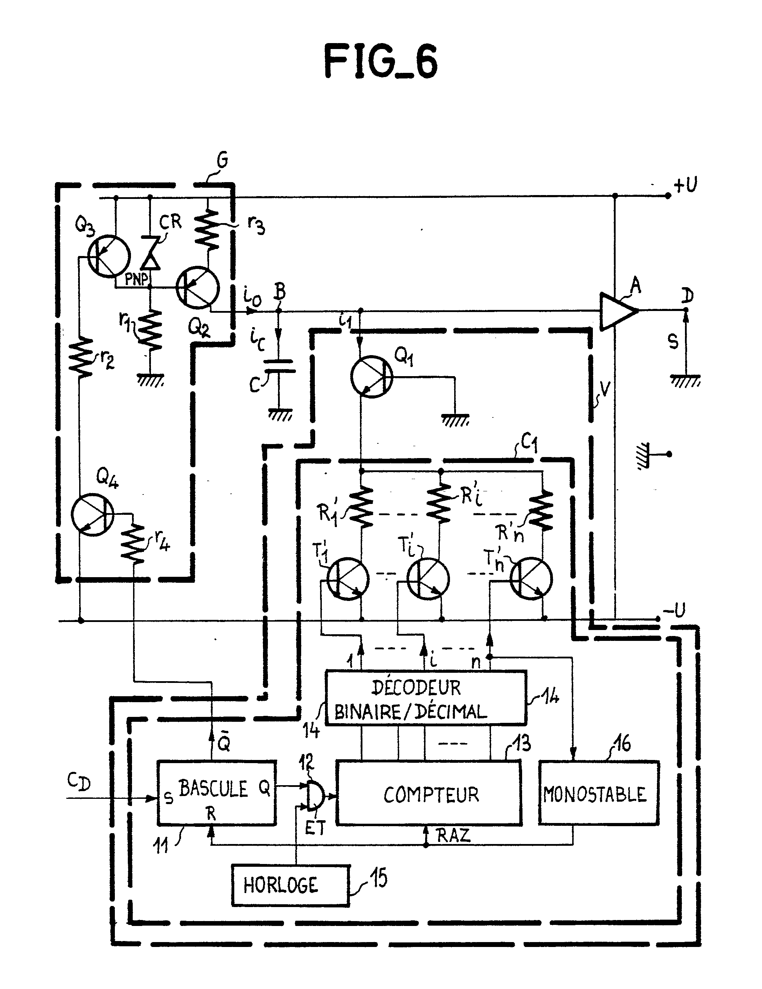

La figure 6 représente un mode de réalisation pratique du schéma de la figure 5.

Sur cette figure, on retrouve le générateur G dont la constitution a été détaillée, le condensateur C, l'amplificateur A et les moyens V dont la constitution a également été détaillée.

Le générateur G comporte donc, relié à une ligne d'alimentation positive repérée +U, un transistor $Q_3$ de type PNP dont l'émetteur est relié à l'alimentation +U, le collecteur à la masse par l'intermédiaire d'une résistance $r_1$ et la base, par l'intermédiaire d'une résistance $r_2$, au collecteur d'un transistor $Q_4$ de type NPN ; l'émetteur du transistor $Q_4$ est relié à une ligne d'alimentation négative, repérée -U. Le collecteur du transistor $Q_3$ est en outre relié, d'une part, à une diode Zener $C_R$ dont l'autre borne est reliée à l'alimentation +U et, d'autre part, à la base d'un transistor $Q_2$ de type

PNP. L'émetteur de ce transistor $Q_2$ est relié également à l'alimentation +U par l'intermédiaire d'une résistance $r_3$ et le collecteur de ce même transistor $Q_2$ est relié au point B.

Les moyens de variation V comportent un transistor $Q_1$, par exemple de type NPN, dont le collecteur est relié au point B, la base à la masse et l'émetteur aux moyens de commande $C_1$ du courant $i_i$ qui traverse le transistor $Q_1$.

Le circuit de commande $C_1$ consiste principalement en une série de $n$ voies en parallèles, chacune des voies comportant une résistance $R'_i$ et un interrupteur commandable, réalisé par un transistor $T'_i$ et commandé de façon analogue à ce qui est décrit figure 4. Plus précisément, chacun des transistors $T'_i$ de type NPN est donc relié par son collecteur à la résistance $R'_i$ et par son émetteur à l'alimentation -U, sa base étant reliée à une sortie $i$ d'un décodeur binaire-décimal 14. Le circuit de commande $C_1$ comporte en outre une bascule 11, une horloge 15, une porte ET 12, un compteur 13 et un monostable 16.

Le fonctionnement en est le suivant. Avant l'instant $t_0$ (figure 2), la commande $C_D$ est à zéro ; la sortie Q de la bascule 11 est donc à zéro, fermant la porte ET 12 interposée entre le compteur 13

et l'horloge 15. La sortie $\overline{Q}$ de la bascule 11 est alors à 1 ; cette sortie $\overline{Q}$ est reliée par l'intermédiaire d'une résistance $r_4$ à la base du transistor $Q_4$ ; celui-ci alors conduit ; par suite, le transistor $Q_3$ conduit également ce qui court-circuite la diode $C_R$. Le transistor $Q_2$ est alors bloqué et le courant $i_0$ est nul. Le signal de sortie S est donc nul également.

Après l'instant $t_0$, le signal de commande $C_D$ provoque le basculement de l'élément 11, sa sortie Q passant à 1 et sa sortie $\overline{Q}$ à zéro. La sortie $\overline{Q}$ étant à zéro, le transistor $Q_4$ est bloqué entrainant le blocage du transistor $Q_3$, ce qui permet au transistor $Q_2$ de conduire et d'établir ainsi le courant $i_0$. La sortie Q de la bascule 11 à 1 permet d'ouvrir la porte ET 12 entre l'horloge 15 et le compteur 13 ; le compteur 13 compte alors les tops de l'horloge 15 (de période T). Le décodeur 14 est relié au compteur 13 et au transistor $T'_i$ comme sur la figure 4 l'était le décodeur 4 au compteur 3 et au transistor $T_i$. Le fonctionnement est alors analogue à celui de la figure 4 et le décodeur 14 commande successivement les transistors $T'_1$ à $T'_N$. Lorsque l'un de ces transistors $T'_i$ conduit, le courant $i_i$ s'établit dans le transistor $Q_1$ et la valeur de ce courant est une fonction directe de la valeur de la résistance $R'_i$ correspondante ; le

condensateur C se charge alors avec la différence de courant $i_o - i_l$. La tension aux bornes du condensateur C est prélevée par l'amplificateur A pour donner le signal S.

A l'instant $t_l$, lorsque le compteur 13 a totalisé n tops d'horloge, le monostable 16 connecté à la sortie n du décodeur 14 reçoit une impulsion de cette sortie et délivre donc un signal à la fois sur l'entrée de remise à zéro du compteur 13 et sur l'entrée R (reset) de la bascule 11. Cela a pour effet de changer l'état de la bascule 11, la sortie $Q_o$ revenant à zéro et la sortie $\overline{Q}$ à 1 et le circuit se retrouve dans l'état antérieur à l'instant $t_o$. Il est alors prêt à reformer une nouvelle impulsion.

**Revendications**

1. Dispositif de génération d'un signal complexe, caractérisé par le fait qu'il comporte des moyens - (G) de génération d'un courant constant ($i_o$) alimentant deux branches d'un circuit montées en parallèle, la première branche comportant un condensateur (C) et la deuxième branche comportant des moyens (V) assurant la variation du courant ($i_l$) qui y circule et, par suite, du courant ($i_c$) circulant dans la première branche , que le signal de sortie (S) est prélevé aux bornes du condensateur, et que ladite variation est assurée de sorte à obtenir à chaque instant un signal de sortie qui soit au moins une approximation du signal complexe à engendrer.

2. Dispositif selon la revendication 1, caractérisée en ce que ladite variation est assurée de façon discrète.

3. Dispositif selon la revendication 1, caractérisé par le fait que les moyens (V) de variation du courant ($i_l$) circulant dans la deuxième branche comportent n voies, chacune des voies comportant une résistance ($R_i$ ) en série avec un interrupteur - ($K_i$), les moyens (V) de variation comportant en outre un circuit ($C_M$) de commande des interrupteurs de sorte à connecter successivement chacune des n résistances ($R_i$) en parallèle avec le condensateur (C), la valeur de chaque résistance - ($R_i$) étant déterminée en fonction de la pente désirée pour le signal de sortie (S) à l'instant où elle est connectée au condensateur (C).

4. Dispositif selon la revendication 1, caractérisé par le fait que les moyens (V) de variation du courant ($i_l$) circulant dans la deuxième branche comportent un deuxième générateur ($G_l$) de courant constant, ce dernier courant prenant successivement n valeurs sous la commande d'un circuit - ($C_l$) de commande, lesdites n valeurs étant déterminées en fonction de la pente désirée pour le signal de sortie (S) à l'instant correspondant.

5. Dispositif selon la revendication 4, caractérisé par le fait que le circuit de commande comporte n voies, chacune des voies comportant une résistance ($R'_i$) et un interrupteur en série, les interrupteurs étant commandés par un circuit logique de sorte à connecter successivement chacune des voies au deuxième générateur ($G_l$) de courant constant.

6. Dispositif selon l'une des revendications 3 ou 5, caractérisé par le fait que les interrupteurs sont réalisés chacun par un transistor.

**FIG_1**

$i_0$  B  $i_c$  $i_1$

G

V

CIRCUIT DE
VARIATION
DE $i_1$

C

S

$C_D$

**FIG_2**

$m_3$  $m_4$

$b_3$  $b_4$

$S_T$

$m_2$

$b_5$  $m_5$

$b_2$

$m_1$  $b_1$

$b_6$  $m_6$

t

T  1T  2T  3T  4T  5T  6T

$t_0$  $t_1$

**FIG_3**

$i_0$  B  $i_1$  A  D

G

$i_c$

$C_M$

$R_1$  $R_2$  $R_i$  $R_n$

C

CIRCUIT

COM-
MANDE

$K_1$  $K_2$  $K_i$  $K_n$

S

$C_D$

V

# FIG_4

# FIG_5

# FIG_6

<table>
<tr><td>Office européen des brevets</td><td>RAPPORT DE RECHERCHE EUROPEENNE</td><td>Numero de la demande<br>EP 86 40 0685</td></tr>
</table>

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | US-A-4 197 509 (CURRAN et al.) <br> * Figures 1,2; colonne 4, ligne 45 - colonne 7, ligne 7 * | 1,2 | H 03 K 4/02 <br> G 06 G 7/28 |
| A | | 3,4 | |
| | --- | | |
| A | EP-A-0 040 541 (NIPPON ELECTRIC) <br> * Figures 6-10; page 16, ligne 5 - page 22, ligne 3 * | 1 | |
| | --- | | |
| A | FR-A-1 509 840 (THE SOLARTRON ELECTRONIC GROUP) <br> * Figures 1-6; page 2, colonne de gauche, ligne 46 - page 5, colonne de gauche, ligne 6 * | 1 | |
| | --- | | **DOMAINES TECHNIQUES RECHERCHES (Int. Cl.4)** |
| A | EP-A-0 031 139 (SIEMENS AG) <br> * Figure 1; revendication 1 * | 1 | H 03 K <br> G 06 G <br> G 01 S |
| | --- | | |
| A | DE-A-2 441 581 (SIEMENS AG) <br> * Figure 1; revendication 1 * | 1 | |
| | ----- | | |

Le présent rapport de recherche a été établi pour toutes les revendications

| Lieu de la recherche <br> LA HAYE | Date d'achèvement de la recherche <br> 25-08-1986 | Examinateur <br> GYSEN L.A.D. |
|---|---|---|